# EUROPÄISCHE PATENTANMELDUNG

(11) **EP 3 670 695 A1**
(43) Veröffentlichungstag der Anmeldung: **24.06.2020**
(21) Anmeldenummer: 19208223.8
(22) Anmeldetag: 11.11.2019
(51) Int. Cl.: C23C 10/02, C23C 10/18, C23C 10/20, C23C 10/22, C23C 10/60, C23C 14/14, C23C 14/16, C23C 14/58, C25D 11/00, C25D 11/02, C25D 11/04, C21D 9/46

(54) **STAHLSUBSTRAT ZUR HERSTELLUNG EINES WARMUMGEFORMTEN UND PRESSGEHÄRTETEN STAHLBLECHBAUTEILS SOWIE WARMUMFORMVERFAHREN**

(30) Priorität: 18.12.2018 DE 102018222063
(71) Anmelder: Volkswagen AG, 38440 Wolfsburg (DE)
(72) Erfinder: Opitz, Tobias, 38106 Braunschweig (DE); Kotzian, Mathias, 38446 Wolfsburg (DE)

(57) **Zusammenfassung**

Die Erfindung betrifft ein Stahlsubstrat zur Herstellung eines warmumgeformten und pressgehärteten Stahlblechbauteils in einem Warmumformverfahren, bei dem das Stahlsubstrat (1) in einem Wärmebehandlungsschritt (III) auf über die Austenitisierungstemperatur Ac3 wärmebehandelt wird, in einem Einlegeschritt (IV) das wärmebehandelte Stahlsubstrat (1) im Umformwerkzeug eingelegt wird und in einem Presshärteschritt (V) das Stahlsubstrat (1) warmumgeformt wird und abgekühlt wird, und zwar unter Bildung des Stahlblechbauteils, wobei das Stahlsubstrat (1), insbesondere ein härtbarer, kohlenstoff-, bor- und/oder manganhaltiger Vergütungsstahl, mit einer Zunderschutzschicht (5) beschichtet ist. Erfindungsgemäß ist die Zunderschutzschicht (5) eine Dünnschicht, die vor dem Wärmebehandlungsschritt (III) in einem Beschichtungsschritt (I) auf das Stahlsubstrat (1) aufbringbar ist.

## Beschreibung

Die Erfindung betrifft ein Stahlsubstrat zur Herstellung eines warmumgeformten und pressgehärteten Stahlblechbauteils nach dem Oberbegriff des Anspruches 1 sowie ein Warmumformverfahren nach dem Anspruch 9.

Warmumformstähle, wie zum Beispiel 22MnB5, weisen nach dem Warmumformprozess ein nahezu vollständiges martensitisches Gefüge mit einer nominellen Zugfestigkeit Rm von 1500MPa auf. Aktuell werden die Festigkeiten dieser Warmumformstähle durch zum Beispiel eine Erhöhung des Kohlenstoffanteils im Stahlsubstrat weiter bis auf 2000MPa gesteigert.

In einem gattungsgemäßen Warmumformverfahren wird das Stahlsubstrat als noch unbeschichtetes, aufgewickeltes Bandmaterial (Coil) bereitgestellt. Vor dem Warmumformprozess erfolgt ein Schmelztauchprozess, in dem das Stahlsubstrat mit einer AlSi-Schicht beschichtet wird, die als Zunderschutzschicht wirkt. Zur Durchführung des Schmelztauchprozesses wird das aufgewickelte Bandmaterial in einer Wickelstation in Fertigungsrichtung abgewickelt und durch ein Schmelzbad gefördert, in dem das Bandmaterial mit der AlSi-Schicht beschichtet wird. Das mit AISi beschichtete Bandmaterial wird in einer weiteren Wickelstation wieder aufgewickelt und zu einer Pressenanlage transportiert, in der es zu Blechplatinen zugeschnitten wird. Die Blechplatinen werden in der Pressenanlage einem an sich bekannten Warmumformprozess unterworfen, bei dem die Blechplatine in einem Wärmebehandlungsschritt im Rollenherdofen auf über die Austenitisierungstemperatur wärmebehandelt wird, in einem Einlegeschritt die wärmebehandelte Blechplatine im Umformwerkzeug eingelegt wird, und in einem Presshärteschritt die Blechplatine warmumgeformt und abgekühlt wird, und zwar unter Bildung des Stahlblechbauteils.

Im Stand der Technik weist die im Schmelztauchverfahren auf das Stahlsubstrat aufgebrachte AlSi-Schicht eine Schichtdicke im Bereich von 20µm bis 40µm auf. Bei einer solchen Schichtdicke bildet die AlSi-Schicht eine geschlossene Deckschicht, bei der die H₂-Permeabilität bei Raumtemperatur stark eingeschränkt ist..

Die große Schichtdicke der AlSi-Schicht führt jedoch zu einer hohen Verweildauer im Rollenherdofen, damit ein vollständiges Eindiffundieren der AlSi-Schicht in das Stahlsubstrat gewährleistet ist.

Die AlSi-Schicht wirkt ferner aufgrund ihrer großen Schichtdicke als eine H₂-Barriere, deren Sperrwirkung temperaturabhängig ist. Die H₂-Sperrwirkung der AlSi-Schicht beeinträchtigt nach dem Wärmebehandlungsschritt eine H₂-Effusion, bei der der Anteil von im Stahlsubstrat eingelagertem Wasserstoff reduziert wird. Ein solcher H₂-Eintrag aus der Ofenatmosphäre findet bekanntermaßen im Wärmebehandlungsschritt im Rollenherdofen statt. Der H₂-Eintrag führt zu einer H₂-Versprödung. Auf die H₂-Versprödung reagieren vor allem höchstfeste Stähle, zum Beispiel 34MnB5, sensibel, und zwar mit einer H₂-induzierten Rissbildung (delayed fracture), die unter anderem beim nachgeschalteten Verbau des fertiggestellten Warmumformstahlblechteils in der Fahrzeugkarosserie auftreten kann. Um die H₂-induzierte Rissbildung beim Verbau in die Fahrzeugkarosserie zu vermeiden, müssen speziell bei Stahlsubstraten für hoch- und/oder höchstfeste Stahlblechteile prozesstechnisch aufwendige Maßnahmen bereitgestellt werden. Beispielhaft kann dem Warmumformprozess ein prozesstechnisch aufwendiges Anlassen nachgeschaltet sein, um eine H₂-Effusion zu begünstigen.

Zudem geht im Stand der Technik die AlSi-Schicht im Wärmebehandlungsschritt in eine schmelzflüssige Phase über, wodurch das AISi in die Keramik-Rollen des Rollenherdofens eindiffundieren kann. Dies kann zu einem frühzeitigen Rollenbruch führen.

Aus der US 2016/0122889 A1 ist ein Verfahren zum Herstellen eines Erzeugnisses aus flexibel gewalztem Bandmaterial bekannt.

Die Aufgabe der Erfindung besteht darin, ein Stahlsubstrat zur Herstellung eines warmumgeformten und pressgehärteten Stahlblechbauteils bereitzustellen, mittels dem ein Warmumformverfahren im Hinblick auf eine automatisierte Serienproduktion verbessert ist.

Die Aufgabe ist durch die Merkmale des Anspruches 1 oder 9 gelöst. Bevorzugte Weiterbildungen der Erfindung sind in den Unteransprüchen offenbart.

Bei der Erfindung wird die Zunderschutzschicht als eine Dünnschicht auf das Stahlsubstrat aufgebracht, und zwar mittels eines geeigneten physikalischen Gasphasen-Abscheidungs-Verfahrens. Das physikalische Gasphasen-Abscheidungs-Verfahren kann bevorzugt als ein PVD-Prozess realisiert sein, oder alternativ als ein thermisches Verdampfen oder ein JVD-Prozess (jet vapour deposition). Nachfolgend wird die Erfindung lediglich beispielhaft speziell mit Bezug auf den PVD-Prozess beschrieben, bei dem eine PVD-Schicht aufgebracht wird. Es ist jedoch hervorzuheben, dass die Erfindung nicht auf den PVD-Prozess beschränkt ist.

So ist gemäß dem kennzeichnenden Teil des Anspruches 1 ist die Zunderschutzschicht nicht mehr als eine AlSi-Schicht realisiert, sondern vielmehr als eine PVD-Dünnschicht ausgebildet, die vor dem Wärmebehandlungsschritt in einem PVD-Beschichtungsschritt auf das Stahlsubstrat aufdampfbar ist. Die PVD-Dünnschicht kann eine im Vergleich zur AlSi-Schicht wesentlich reduzierte Schichtdicke aufweisen, die bereits in einem Bereich von 0,1µm bis 5µm einen Luftkontakt des Stahlsubstrats (und damit eine Zunderbildung) verhindert. Zudem führt die stark reduzierte Schichtdicke zu einer wesentlich reduzierten Diffusionszeitdauer im Wärmebehandlungsofen, bei der die PVD-Dünnschicht in das Stahlsubstrat eindiffundiert.

Bei einer üblichen AlSi-Schicht ist beispielhaft eine Diffusionszeit von z.B. 45 bis 60 s nach Erreichen der Austenitisierungstemperatur erforderlich, um die Schicht-Ausbildung zu gewährleisten. Demgegenüber ist bei der erfindungsgemäßen PVD-Dünnschicht (aufgrund der kleineren Diffusionswege) die Diffusionszeit bis auf wenige Sekunden reduziert. Auf diese Weise kann der Wärmebehandlungsschritt im Rollenherdofen mit einer insgesamt stark reduzierten Prozesszeitdauer erfolgen.

Die PVD-Dünnschicht kann einseitig oder beidseitig in einer PVD-Anlage auf das Stahlsubstrat aufgebracht werden.

Die Verwendung der erfindungsgemäßen PVD-Dünnschicht als Zunderschutzschicht ist insbesondere bei einem Stahlsubstrat von Vorteil, das einer Werkstoff-Güteklasse zur Herstellung von hoch- und/oder höchstfesten Stahlblechbauteilen zugeordnet ist. Im gehärteten Zustand liegt deren Zugfestigkeit bei Rm > 1400MPa, bevorzugt Rm > 1700MPa, insbesondere Rm > 1800MPa. Beispielhaft kann das Stahlsubstrat 22MnB5, 34MnB5 oder 36MnB5 sein.

Aufgrund der im Vergleich zu einer herkömmlichen AlSi-Schicht stark reduzierten Schichtdicke ist bei der PVD-Dünnschicht die für eine H₂-Effusion erforderliche Zeit stark reduziert, um einen kritischen Grenzwert des H₂-Gehalts zu unterschreiten. Dadurch wird nach dem Wärmebehandlungsschritt eine H₂-Effusion begünstig, bei der der Anteil von im Stahlsubstrat eingelagertem Wasserstoff reduziert wird, und zwar ohne Bereitstellung von prozesstechnisch aufwendigen Zusatzmaßnahmen. Das Risiko einer H₂-induzierten Rissbildung beim Verbau des fertiggestellten Warmumformstahlblechteils in der Fahrzeugkarosserie kann daher ohne Zusatzmaßnahmen (etwa einem Anlassen) reduziert werden. Vor diesem Hintergrund ist die Erfindung speziell in Kombination mit einem Stahlsubstrat einer Werkstoff-Güteklasse zur Herstellung von hoch- und/oder höchstfesten Stahlblechbauteilen von Vorteil, die auf eine H₂-Versprödung sensibel, das heißt mit einer H₂-induzierten Rissbildung reagieren.

Als Beschichtungsmaterial zur Herstellung der PVD-Dünnschicht kann jegliches geeignetes Metall oder Nichtmetall verwendet werden, insbesondere Aluminium, Zink, Eisen und spezifische Legierungen der Elemente und Oxide (d.h. ZnₓO_{y}, AlₓMg_{y}, AlₓFe_{y}, ZnₓFe_{y}). Zudem kann die PVD-Dünnschicht Bestandteil eines mehrlagigen Beschichtungssystems sein, die zumindest eine erste PVD-Dünnschicht und eine zweite PVD-Dünnschicht aufweist. Die beiden PVD-Dünnschichten können unterschiedliche Beschichtungsmaterialien aufweisen. Neben einem solchen mehrlagigen Aufbau ist auch eine reaktive Beschichtung möglich.

In der PVD-Anlage wird das Beschichtungsmaterial aus einer Gasphase auf das Stahlsubstrat aufgedampft und kondensiert dort unter Bildung einer PVD-Dünnschicht. Bevorzugt ist es, wenn nach dem PVD-Beschichtungsschritt ein Nachbehandlungsschritt folgt, in dem diverse Prozesseigenschaften oder Weiterverarbeitungseigenschaften verbessert werden. Der Nachbehandlungsschritt ist dem eigentlichen Warmumformprozess bevorzugt prozesstechnisch vorgelagert. Beispielhaft kann ein Beschichtungsmaterial im PVD-Beschichtungsschritt Aluminium verwendet werden. In diesem Fall kann der Nachbehandlungsschritt als ein Anodisierschritt realisiert sein, bei dem aus der PVD-Dünnschicht (bestehend aus Aluminium) eine Aluminiumoxidschicht erzeugt wird.

Alternativ dazu kann im Nachbehandlungsschritt eine Wärmebehandlung erfolgen, bei der die PVD-Dünnschicht durch Wärmeeinwirkung aufgeschmolzen wird. Dadurch erfolgt bereits vor der Wärmebehandlung im Rollenherdofen eine Vordiffusion. Für die Vordiffusion wird die PVD-Dünnschicht durch Wärmeeinwirkung zu einer schmelzflüssigen Phase aufgeschmolzen, die zumindest teilweise oder komplett in das Stahlsubstrat eindiffundiert. Im eigentlichen Wärmebehandlungsschritt im Rollenherdofen erfolgt somit lediglich eine Nachdiffusion, bei der die noch nicht eindiffundierte PVD-Dünnschicht in das Stahlsubstrat eindiffundiert wird.

Der Schmelzpunkt der bei der Vordiffusion anlegierten Schicht kann sich vorteilhaft erhöhen. Dies führt zu einer Verminderung der Flüssigphasenbildung im Warmumformprozess. Im Extremfall liegt die Schmelztemperatur der anlegierten Schicht bereits vor dem Ofendurchlauf oberhalb der Wärmebehandlungstemperatur im Rollenherdofen.

Die im obigen Nachbehandlungsschritt entstehende vordiffundierte PVD-Dünnschicht führt außerdem (zumindest bei einem Übergang von Aluminium zu Aluminium-Eisen) zu einem - im Vergleich zu der noch nicht diffundierten PVD-Dünnschicht - höheren Emissionskoeffizienten des Stahlsubstrates (das heißt dunklere Schicht beschleunigt die Erwärmung).

Zur Bereitstellung eines für eine automatisierte Serienproduktion geeigneten Prozessabfolge ist es bevorzugt, wenn das Stahlsubstrat ein aufgewickeltes Bandmaterial ist. Das aufgewickelte Bandmaterial kann zur Vorbereitung des PVD-Beschichtungsschrittes in einer ersten Wickelstation in Fertigungsrichtung abgewickelt werden und kontinuierlich durch eine PVD-Anlage geführt werden. Nach erfolgter PVD-Beschichtung kann das Bandmaterial in einer zweiten Wickelstation wieder aufgewickelt werden. Das aufgewickelte und bereits beschichtete Bandmaterial kann zu einer Schneidstation (Platinenschneidanlage oder Laserschneidanlage) transportiert werden, in der Blechplatinen zugeschnitten werden. Diese werden in einer nachgeschalteten Pressenanlage dem Warmumformprozess unterworfen.

Nachfolgend ist ein Ausführungsbeispiel der Erfindung anhand der beigefügten Figuren beschrieben.

Es zeigen:
- Figur 1: ein Blockschaltdiagramm, anhand dem eine Prozessroute zur Warmumformung eines dünnbeschichteten Stahlsubstrats veranschaulicht ist;
- Figur 2: in grob schematischer Darstellung eine PVD-Anlage,;
- Figur 3: ein Schliffbild, das im Querschnitt ein aus dem Stand der Technik bekanntes, mit einer AlSi-Schicht beschichtetes Stahlsubstrat nach dem Beschichtungsschritt zeigt; und
- Figur 4: ein Schliffbild, das im Querschnitt ein erfindungsgemäßes, mit einer PVD-Dünnschicht beschichtetes Stahlsubstrat nach dem PVD-Beschichtungsschritt zeigt.

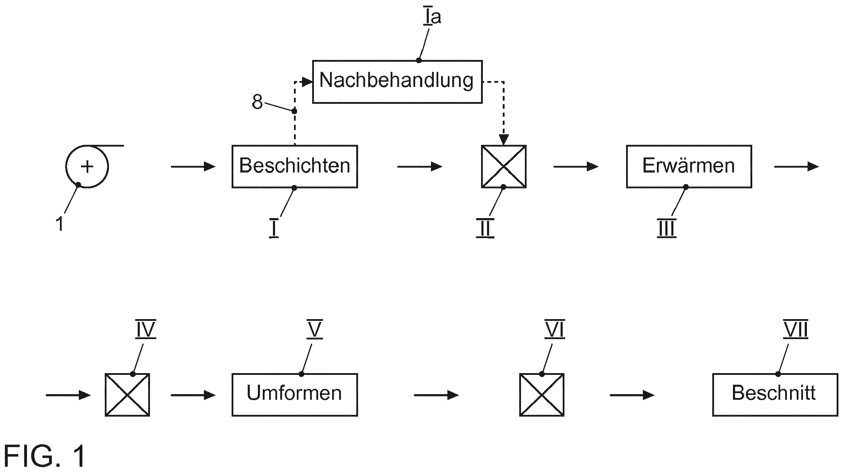

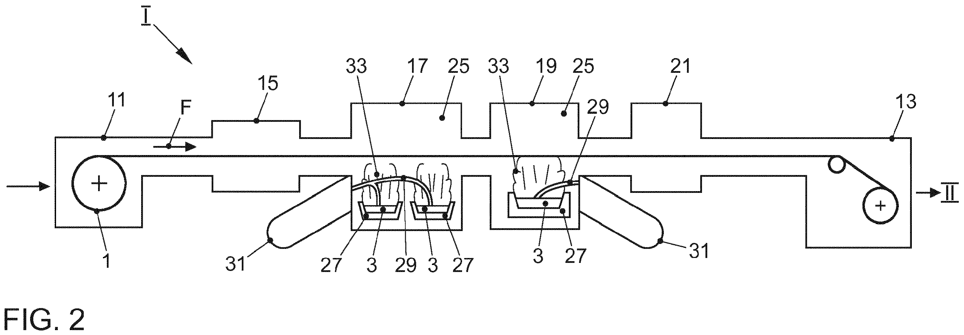

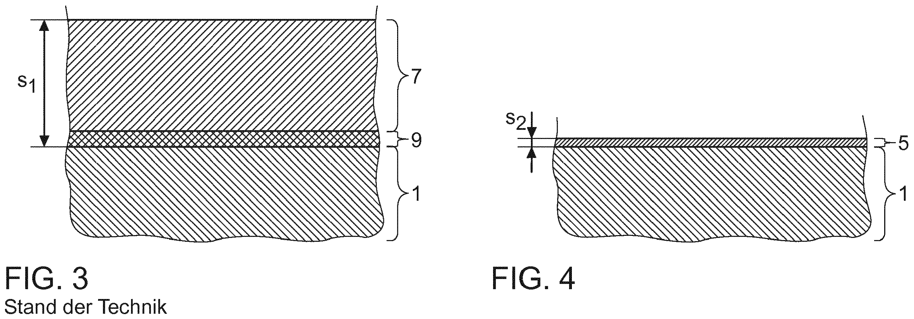

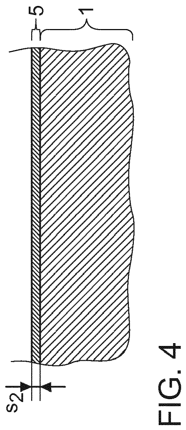

Nachfolgend wird anhand der Figur 1 eine grundsätzliche Prozessabfolge bzw. Prozessroute zur Herstellung eines warmumgeformten und pressgehärteten Stahlblechteils erläutert. Demzufolge wird ein noch unbeschichtetes Stahlsubstrat 1 als ein aufgewickeltes Bandmaterial (Coil) bereitgestellt. Das aufgewickelte Bandmaterial 1 wird einem PVD-Beschichtungsschritt I unterworfen, der später anhand der Figur 2 detailliert beschrieben ist. Im PVD-Beschichtungsschritt I findet eine PVD-Beschichtung statt, bei der ein Beschichtungsmaterial 3 (Figur 2) in einer physikalischen Gasphasenabscheidung (PVD) als eine PVD-Dünnschicht 5 (Figur 4) auf das Stahlsubstrat 1 aufgedampft wird. Anschließend erfolgt ein Schneidschritt II, bei dem das nunmehr beschichtete Bandmaterial 1 in einer Schneidstation II zu einer Blechplatine zugeschnitten wird. Die Blechplatine wird nachfolgend dem eigentlichen Warmumformprozess zugeführt, der in der Figur 1 durch die Prozessschritte III bis VII veranschaulicht ist. Demzufolge wird die mit der PVD-Dünnschicht 5 beschichtete Blechplatine in einem Wärmebehandlungsschritt III auf über die Austenitisierungstemperatur Ac3 zum Beispiel in einem Rollenherdofen wärmebehandelt. Anschließend erfolgt ein Einlegeschritt IV, bei dem die wärmebehandelte Blechplatine im Heißzustand in ein Umformwerkzeug eingelegt und darin zentriert wird. Danach wird ein Presshärteschritt V durchgeführt, bei dem die Blechplatine warmumgeformt wird und abgekühlt wird, und zwar unter Bildung des Stahlblechbauteils. Das Stahlblechbauteil wird im Umformwerkzeug bis auf eine Entnahmetemperatur abgekühlt. Anschließend wird eine Bauteilentnahme VI durchgeführt, bei der das Stahlblechbauteil aus dem Warmumformwerkzeug entnommen wird. In einem abschließenden Nachbearbeitungsschritt VII erfolgt eine Nachbearbeitung des Stahlblechbauteils, beispielhaft ein Beschnitt oder dergleichen.

Die Figur 3 zeigt, wie auch die Figur 4, ein Schliffbild. In der Figur 3 ist eine, in einem üblichen Schmelztauchverfahren auf das Stahlsubstrat 1 aufgebrachte AlSi-Schicht 7 gezeigt. Deren Schichtdicke s₁ ist wesentlich größer als die Schichtdicke s₂ in der, in der Figur 3 dargestellten PVD-Dünnschicht 5. Die hohe Schmelzbadtemperatur führt in der Figur 3 bereits im Beschichtungsschritt zu einer Diffusion, bei der die noch flüssige AlSi-Schicht 7 teilweise in das Stahlsubstrat 1 eindiffundiert, und zwar unter Bildung der oben erwähnten Interdiffusionsschicht 9. Diese besteht aus einer intermetallischen Phase aus Al-Fe und Si.

Wie aus der Figur 4 hervorgeht, weist die im Beschichtungsschritt I auf das Stahlsubstrat 1 aufgebrachte PVD-Dünnschicht 5 eine Schichtdicke s₂ auf, die zwischen 0,1µm und 5µm liegt. Es ist hervorzuheben, dass sich im PVD-Beschichtungsschritt I keine Interdiffusionsschicht 9 ausbildet, und zwar im Gegensatz zu einem, in einem Standard-Schmelztauchprozess schmelztauchveredelten Stahlsubstrat 1, wie es in der Figur 3 angedeutet ist.

Erfindungsgemäß wird die PVD-Dünnschicht 5 - aufgrund ihrer geringen Schichtdicke s₂ - im Wärmebehandlungsschritt III nahezu schlagartig in das Stahlsubstrat 1 eindiffundiert. Von daher liegt erfindungsgemäß die im Wärmebehandlungsofen erforderliche Diffusionszeit nur bei wenigen Sekunden (ca. 3 bis 10 s), und zwar im Vergleich zu einer Diffusionszeit von 2,5 min, wie sie bei einem mit AISi (Figur 3) beschichteten Stahlsubstrat 1 erforderlich ist.

In der Figur 1 ist durch gestrichelte Teile eine alternative Prozessroute angedeutet, bei der dem Beschichtungsschritt I ein Nachbehandlungsschritt la prozesstechnisch nachgelagert ist, in dem die Prozesseigenschaften des beschichteten Stahlsubstrats 1 verbessert werden können. Speziell bei Verwendung von Aluminium als Beschichtungsmaterial 3 für die PVD-Dünnschicht 5 kann der Nachbearbeitungsschritt ein Anodisierschritt sein, bei dem aus der PVD-Dünnschicht 5 (aus Aluminium) eine Aluminiumoxidschicht erzeugt wird.

Alternativ dazu kann im Nachbehandlungsschritt la eine Vordiffusion erfolgen, bei der die PVD-Dünnschicht 5 durch Wärmeeinwirkung zu einer schmelzflüssigen Phase aufgeschmolzen wird. Der Schmelzpunkt der bei der Vordiffusion anlegierten Schicht kann sich vorteilhaft erhöhen. Dies führt zu einer Verminderung der Flüssigphasenbildung im Warmumformprozess. Im Extremfall liegt die Schmelztemperatur der bei der Vordiffusion anlegierten Schicht bereits vor dem Ofendurchlauf oberhalb der Wärmebehandlungstemperatur im Rollenherdofen, wodurch eine Verunreinigung der Rollen im Rollenherdofen vermieden wird.

Wie oben erwähnt, wird im Nachbehandlungsschritt la bereits vor der Durchführung des Warmumformprozesses (Schritte III bis VII) die PVD-Dünnschicht 5 in das Stahlsubstrat 1 vordiffundiert. Dadurch stellt sich im Stahlsubstrat 1 ein - im Vergleich zu einer noch nicht diffundierten PVD-Dünnschicht - größerer Emissionskoeffizient (zumindest bei einem Übergang von Aluminium zu Aluminium-Eisen) ein, das heißt das Stahlsubstrat 1 ist dunkler. Entsprechend wird eine Erwärmung im Rollenherdofen zusätzlich beschleunigt.

Anhand der Figur 2 wird nachfolgend grob schematisch der Aufbau und die Funktionsweise einer PVD-Anlage beschrieben, mittels der der Beschichtungsschritt I durchführbar ist, bei dem beispielhaft lediglich einseitig beschichtet wird. Die PVD-Anlage weist in der Figur 1 eine Wickelstation 11, eine Vorbehandlungsstation 15, eine erste Beschichtungsstation 17, eine zweite Beschichtungsstation 19, eine Nachbehandlungsstation 21 und eine zweite Wickelstation 13 auf, die in einer Fertigungsrichtung F hintereinander geschaltet sind.

Zur Vorbereitung des PVD-Beschichtungsschrittes I wird das Bandmaterial 1 in der ersten Wickelstation 11 abgewickelt und in Fertigungsrichtung F kontinuierlich in die Vorbehandlungsstation 15 und weiter in die beiden Beschichtungsstationen 17 und 19 geführt. Die erste Beschichtungsstation 17 weist eine evakuierte Beschichtungskammer 25 auf, in der zwei Tiegel 27 angeordnet sind. In jedem der Tiegel 27 sind Ausgangskomponenten von Beschichtungsmaterialien 3 in fester Form angeordnet. Durch den Beschuss mit einem Elektronenstrahl 29 aus einer Hochleistungs-Elektronenkanone 31 werden die Beschichtungsmaterialien 3 zu einer Gasphase 33 verdampft. Das gasförmige Material wird anschließend dem Bandmaterial 1 zugeführt, wo es unter Bildung der PVD-Dünnschicht 5 kondensiert. Die nachgeschaltete zweite Beschichtungsstation 19 ist identisch aufgebaut, mit der Ausnahme, dass lediglich ein einziger Tiegel 27 mit Beschichtungsmaterial 3 in der Beschichtungskammer 25 positioniert ist. Im Anschluss an die zweite Beschichtungsstation 19 wird das beschichtete Bandmaterial in die Nachbehandlungsstation 21 und weiter in die zweite Wickelstation 13 geführt. In der zweiten Wickelstation 13 wird das beschichtete Bandmaterial wieder aufgewickelt. Das aufgewickelte Bandmaterial wird anschließend zur Schneidstation II transportiert, in der es zu Blechplatinen zugeschnitten wird, die dem weiteren Warmumformprozess (Prozessschritte III bis VII) unterworfen werden.

Mittel gezielter Steuerung kann eine spezifische, gezielte Stöchiometrie eingestellt werden, zum Beispiel Aluminium-Magnesium mit unterschiedlichen Magnesium-Gehalt.

### Bezugszeichenliste

- 1: Stahlsubstrat
- 3: Beschichtungsmaterial
- 5: PVD-Dünnschicht
- 7: AlSi-Schicht
- 9: Interdiffusionsschicht
- 11, 13: Wickelstationen
- 15: Vorbehandlungsstation
- 17: erste Beschichtungsstation
- 19: zweite Beschichtungsstation
- 21: Nachbehandlungsstation
- 25: Beschichtungskammer
- 27: Tiegel
- 29: Elektronenstrahl
- 31: Hochleistungs-Elektronenkanone
- 33: Gasphase
- F: Fertigungsrichtung
- I: Beschichtungsschritt
- Ia: Nachbehandlungsschritt
- II: Schneidschritt
- III: Wärmebehandlungsschritt
- IV: Einlegeschritt
- V: Umformschritt
- VI: Bauteilentnahme
- VII: Nachbearbeitungsschritt

## Patentansprüche

1. Stahlsubstrat zur Herstellung eines warmumgeformten und pressgehärteten Stahlblechbauteils in einem Warmumformverfahren, bei dem das Stahlsubstrat (1) in einem Wärmebehandlungsschritt (III) auf über die Austenitisierungstemperatur Ac3 wärmebehandelt wird, in einem Einlegeschritt (IV) das wärmebehandelte Stahlsubstrat (1) im Umformwerkzeug eingelegt wird und in einem Presshärteschritt (V) das Stahlsubstrat (1) warmumgeformt wird und abgekühlt wird, und zwar unter Bildung des Stahlblechbauteils, wobei das Stahlsubstrat (1), insbesondere ein härtbarer, kohlenstoff-, bor- und/oder manganhaltiger Vergütungsstahl, mit einer Zunderschutzschicht (5) beschichtet ist, **dadurch gekennzeichnet, dass** die Zunderschutzschicht (5) eine Dünnschicht ist, die vor dem Wärmebehandlungsschritt (III) in einem Beschichtungsschritt (I) auf das Stahlsubstrat (1) aufbringbar ist.

2. Stahlsubstrat nach Anspruch 1, **dadurch gekennzeichnet, dass** die Dünnschicht in einem physikalischen Gasphasen-Abscheidungs-Verfahren aufgebracht ist.

3. Stahlsubstrat nach Anspruch 2, **dadurch gekennzeichnet, dass** das physikalische Gasphasen-Abscheidungsverfahren ein thermisches Verdampfen, ein PVD-Prozess oder ein JVD-Prozess ist.

4. Stahlsubstrat nach Anspruch 1, 2 oder 3, **dadurch gekennzeichnet, dass** die Dünnschicht (5) eine Schichtdicke (s) kleiner als 5µm aufweist, und/oder dass insbesondere die Schichtdicke (s) größer als 0,1µm ist.

5. Stahlsubstrat nach einem der vorhergehenden Ansprüche, **dadurch gekennzeichnet, dass** das Stahlsubstrat (1) einer Werkstoff-Güteklasse zur Herstellung von Stahlblechteilen zugeordnet ist, deren Zugfestigkeit im gehärteten Zustand bei Rm > 1400MPa liegt, insbesondere 22MnB5.

6. Stahlsubstrat nach einem der vorhergehenden Ansprüche, **dadurch gekennzeichnet, dass** das Stahlsubstrat (1) einer Werkstoff-Güteklasse zur Herstellung hoch- und/oder höchstfester Stahlblechteile zugeordnet ist, deren Zugfestigkeit im gehärteten Zustand bei Rm > 1700MPa, insbesondere Rm > 1800MPa liegt, und/oder dass das Stahlsubstrat insbesondere ein manganhaltiger Vergütungsstahl mit einem Kohlenstoffgehalt >0.22 wt% ist, etwa 34MnB5 oder 36MnB5 ist.

7. Stahlsubstrat nach einem der vorhergehenden Ansprüche, **dadurch gekennzeichnet, dass** das Beschichtungsmaterial (3) zur Herstellung der Dünnschicht (5) jegliches geeignetes Metall oder Nichtmetall ist, insbesondere Aluminium, Zink, Eisen und spezifische Legierungen der Elemente und Oxide (d.h. ZnₓO_{y}, AlₓFe_{y}, AlₓMg_{y}, ZnₓFe_{y}).

8. Stahlsubstrat nach einem der vorhergehenden Ansprüche, **dadurch gekennzeichnet, dass** die Dünnschicht (5) Bestandteil eines mehrlagigen Beschichtungssystems ist, die zumindest eine erste Dünnschicht und eine zweite Dünnschicht aufweist, und dass insbesondere die ersten und zweiten Dünnschichten unterschiedliche Beschichtungsmaterialien (3) aufweisen.

9. Warmumformverfahren zur Herstellung eines warmumgeformten und pressgehärteten Stahlblechbauteils, bei dem in einem Beschichtungsschritt (I) das Stahlsubstrat (1) mit einer Zunderschutzschicht (5) beschichtet wird, in einem Wärmebehandlungsschritt (III) das beschichtete Stahlsubstrat (1) auf über die Austenitisierungstemperatur Ac3 wärmebehandelt wird, in einem Einlegeschritt (IV) das wärmebehandelte Stahlsubstrat (1) in ein Umformwerkzeug eingelegt wird und in einem Presshärteschritt (V) das Stahlsubstrat (1) warmumgeformt und abgekühlt wird, und zwar unter Bildung des Stahlblechbauteils, **dadurch gekennzeichnet, dass** im Beschichtungsschritt (I) eine Beschichtung erfolgt, bei der zumindest ein Beschichtungsmaterial (3) als eine Dünnschicht (5) auf das Stahlsubstrat (1) aufgedampft wird.

10. Warmumformverfahren nach Anspruch 9, **dadurch gekennzeichnet, dass** die Dünnschicht in einem physikalischen Gasphasen-Abscheidungs-Verfahren aufgebracht wird.

11. Warmumformverfahren nach Anspruch 9 oder 10, **dadurch gekennzeichnet, dass** dem Beschichtungsschritt (I) ein Nachbehandlungsschritt (la) prozesstechnisch unmittelbar nachgelagert ist, in dem Prozesseigenschaften und/oder Gebrauchseigenschaften verbessert werden.

12. Warmumformverfahren nach Anspruch 9, 10 oder 11, **dadurch gekennzeichnet, dass** als Beschichtungsmaterial (3) Aluminium verwendet wird, und/oder dass der Nachbehandlungsschritt (la) ein Anodisierschritt ist, bei dem aus der Dünnschicht (5) aus Aluminium eine Aluminiumoxidschicht erzeugt wird.

13. Warmumformverfahren nach Anspruch 12, **dadurch gekennzeichnet, dass** im Nachbehandlungsschritt (la) die Dünnschicht (5) durch Wärmeeinwirkung aufgeschmolzen wird, wodurch eine Vordiffusion erfolgt, bei der die Dünnschicht (5) zumindest teilweise in das Stahlsubstrat (1) eindiffundiert, und/oder dass insbesondere im Wärmebehandlungsschritt (III) eine Nachdiffusion erfolgt, bei der das noch nicht eindiffundierte Rest-Beschichtungsmaterial der Dünnschicht (5) weiter in das Stahlsubstrat (1) eindiffundiert wird.

14. Warmumformverfahren nach einem der Ansprüche 8 bis 11, **dadurch gekennzeichnet, dass** das Stahlsubstrat (1) als ein Bandmaterial bereitgestellt wird, und dass das Bandmaterial in einer Schneidstation (II), insbesondere Laserschneidanlage oder Platinenschneidanlage, zu einer Blechplatine zugeschnitten wird, die anschließend dem Warmumformprozess (III bis VII) zugeführt wird, und dass insbesondere der Beschichtungsschritt (I) vor dem Schneidschritt (II) erfolgt.

15. Warmumformverfahren nach Anspruch 14, **dadurch gekennzeichnet, dass** zur Vorbereitung des Beschichtungsschrittes (I) das Bandmaterial in einer ersten Wickelstation (11) abgewickelt wird, und in einer Fertigungsrichtung (F) durch eine Beschichtungs-Anlage geführt wird, und dass nach erfolgter Beschichtung das Bandmaterial in einer zweiten Wickelstation (13) wieder aufgewickelt wird, und dass das aufgewickelte, bereits beschichtete Bandmaterial in der Schneidstation (II) zu der Blechplatine zugeschnitten wird.

16. Warmumformverfahren nach einem der Ansprüche 9 bis 15, **dadurch gekennzeichnet, dass** im Beschichtungsprozess unterschiedliche Wärmequellen zum Verdampfen des Beschichtungsmaterials genutzt werden, etwa ein Elektronenstrahl-Verdampfen, ein Laser-Verdampfen, ein thermisches Verdampfen oder dergleichen.
